# EUROPEAN PATENT APPLICATION

(11) **EP 4 161 053 A1**
(43) Date of publication of application: **05.04.2023**
(21) Application number: 21813567.1
(22) Date of filing: 27.05.2021
(51) Int. Cl.: H04N 5/225

(54) **CAMERA MODULE AND ELECTRONIC DEVICE**

(30) Priority: 28.05.2020 CN 202010470005
(71) Applicant: Vivo Mobile Communication Co., Ltd., Dongguan, Guangdong 523863 (CN)
(72) Inventor: XU, Bo, Dongguan, Guangdong 523863 (CN); PENG, Shiwei, Dongguan, Guangdong 523863 (CN); GAO, Feng, Dongguan, Guangdong 523863 (CN)
(74) Representative: Raffay & Fleck
(86) International application number: PCT/CN2021/096224
(87) International publication number: WO 2021/239030

(57) **Abstract**

Disclosed are a camera module and an electronic device. The camera module comprises: a holder (100); a lens (200) provided on the holder (100); a substrate (300) connected to the holder (100); and a photosensitive chip module (400) provided on the substrate (300), electrically connected to the substrate (300), arranged opposite the lens (200), and having a light receiving surface (410) facing towards the lens (200), wherein the light receiving surface (410) is a concave surface, and is constituted by connecting multiple protrusions (411) distributed in an array. Also disclosed is an electronic device.

## Description

### CROSS-REFERENCE TO RELATED APPLICATIONS

The present invention claims priority to Chinese Patent Application No. 202010470005.6, filed with the China National Intellectual Property Administration on May 28, 2020 and entitled "CAMERA MODULE AND ELECTRONIC DEVICE", which is incorporated herein by reference in its entirety.

### TECHNICAL FIELD

This application relates to the field of communication device technologies, and in particular, to a camera module and an electronic device.

### BACKGROUND

With rapid development of electronic devices, application of electronic devices becomes increasingly extensive, and electronic devices such as mobile phones and tablet computers play increasing roles in people's work, life, entertainment, and other aspects.

Currently, users propose increasingly high requirements for photographing effects of electronic devices. Usually, because natural light is a mixture of a variety of types of light, in a photographing process of a camera module of an electronic device, after light with different wavelengths is refracted by a lens of the camera module, refractive indexes of different light on the lens are different due to different wavelengths of the different light.

Therefore, to collimate and aggregate light with different wavelengths to one plane, a complex lens with a large size may be used, so that most light can be refracted onto a photosensitive chip of a camera module through the lens. However, because the photosensitive chip of the camera module usually has a planar structure, in a process of collecting images by using the photosensitive chip with the planar structure, image distortion is likely to occur, which easily causes distortion during imaging. In addition, processing of a lens with a complex shape is difficult, which is not conducive to cost control for an electronic device, and a lens with a large size is not conducive to a miniaturized design of an electronic device either.

### SUMMARY

This application discloses a camera module and an electronic device, to resolve a problem that a camera module of an electronic device currently has poor imaging quality.

To resolve the foregoing technical problem, this application is implemented as follows:

According to a first aspect, an embodiment of this application discloses a camera module, including:
a bracket;
a lens, where the lens is disposed on the bracket;
a substrate, where the substrate is connected to the bracket; and
a photosensitive chip module, where the photosensitive chip module is disposed on the substrate, the photosensitive chip module is electrically connected to the substrate, the photosensitive chip module is disposed opposite to the lens, the photosensitive chip module has a light receiving surface facing the lens, the light receiving surface is a concave surface, and the light receiving surface is formed by splicing a plurality of protrusions distributed in an array.

According to a second aspect, an embodiment of this application discloses an electronic device, and the disclosed electronic device includes the foregoing camera module.

The technical solutions used in this application can achieve the following beneficial effects:

In the camera module disclosed in the embodiments of this application, because a distance between a center part of the light receiving surface and the lens is slightly different from a distance between an outer part of the light receiving surface and the lens, an optical path through which oblique light enters the outer part can be reduced, so that an optical path difference between the center part and the outer part is small, which can effectively alleviate imaging distortion. Certainly, the light receiving surface allows most light to be refracted onto the photosensitive chip module through the lens, to facilitate miniaturization of the lens. In addition, the light receiving surface formed by splicing the plurality of protrusions distributed in an array can re-gather light that has been gathered by the lens, thereby reducing a photosensitive area required by the photosensitive chip module, and facilitating a miniaturized design of the camera module.

### BRIEF DESCRIPTION OF DRAWINGS

FIG. 1 is a schematic structural diagram of a camera module according to an embodiment of this application;
FIG. 2 is a schematic structural diagram of a camera module according to another embodiment of this application;
FIG. 3 is a partial schematic structural diagram of a camera module according to an embodiment of this application;
FIG. 4 is a partial schematic enlarged view of a part in a dashed-line block in FIG. 3;
FIG. 5 is a partial schematic structural diagram of a camera module according to another embodiment of this application; and
FIG. 6 is a partial schematic enlarged view of a part in a dashed-line block in FIG. 5.

### Reference signs:

100: bracket, and 110: mounting space;
200: lens;
300: substrate;
400: photosensitive chip module, 410: light receiving surface, 411: protrusion, 420: chip assembly, 421: photosensitive chip, 422: microlens array, 430: light collector, 440: connecting bump, and 450: connecting wire;
500: flexible printed circuit board;
600: connector; and
700: filter.

### DESCRIPTION OF EMBODIMENTS

The following clearly and completely describes the technical solutions in the embodiments of this application with reference to the accompanying drawings in the embodiments of this application. Apparently, the described embodiments are some but not all of the embodiments of this application. All other embodiments obtained by a person of ordinary skill in the art based on the embodiments of this application without creative efforts fall within the protection scope of this application.

The terms "first", "second", and the like in the specification and claims of this application are used to distinguish between similar objects instead of describing a specific order or sequence. It should be understood that the data used in this way is interchangeable in appropriate circumstances, so that the embodiments of this application can be implemented in other orders than the order illustrated or described herein. In addition, in the specification and claims, "and/or" represents at least one of connected objects, and the character "/" typically represents an "or" relationship between the associated objects.

The following describes in detail a camera module provided in the embodiments of this application with reference to the accompanying drawings and by using specific embodiments and application scenarios thereof.

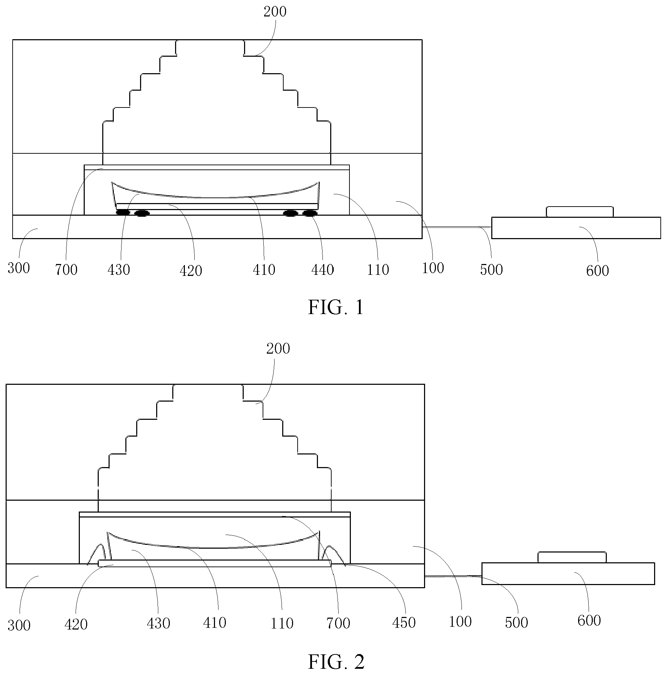

As shown in FIG. 1, an embodiment of this application discloses a camera module. The disclosed camera module may be applied to an electronic device. The camera module includes a bracket 100, a lens 200, a substrate 300, and a photosensitive chip module 400.

The bracket 100 can provide mounting positions for other components of the camera module. The bracket 100 may be provided with an accommodation space, and other components of the camera module may be disposed in the accommodation space, so that a structure of the camera module is more compact.

The lens 200 is disposed on the bracket 100, so that the lens 200 is supported by the bracket 100. The lens 200 can collect light, so that the photosensitive chip module 400 in the camera module can obtain an image by sensing light passing through the lens 200.

The substrate 300 is connected to the bracket 100, and the substrate 300 is configured to carry components such as the photosensitive chip module 400. Specifically, the photosensitive chip module 400 is disposed on the substrate 300, and the photosensitive chip module 400 is electrically connected to the substrate 300. In this case, the substrate 300 is not only used to support the photosensitive chip module 400, but also can be used to control the photosensitive chip module 400. The substrate 300 may be a PCB (Printed Circuit Board, printed circuit board), or the substrate 300 may be a rigid-flex board. This is not limited in this embodiment of this application.

The photosensitive chip module 400 is disposed opposite to the lens 200, so that the lens 200 can gather light to the photosensitive chip module 400, and the photosensitive chip module 400 can finally perform photosensitive imaging.

In this embodiment of this application, the photosensitive chip module 400 has a light receiving surface 410 facing the lens 200, the light receiving surface 410 is a concave surface, and the light receiving surface 410 is formed by splicing a plurality of protrusions 411 distributed in an array. In this case, the light receiving surface 410 is concave in a direction away from the lens 200, so that a distance between a center part of the light receiving surface 410 and the lens 200 is slightly different from a distance between an outer part of the light receiving surface 410 and the lens 200. In addition, the plurality of protrusions 411 refract light to collimate the light, so that the light can propagate in the photosensitive chip module 400 in a direction perpendicular to a photosensitive surface.

The center part of the light receiving surface 410 faces the lens 200. An optical path of light that enters the center part through the lens 200 is L 1, and an optical path of light that enters the outer part through the lens 200 is L. In a case that a surface, of the photosensitive chip module 400, that faces the lens 200 is flat, the distance between the lens 200 and the center part is smaller than the distance between the lens 200 and the outer part. As a result, the optical path of the light entering the outer part is greater than the optical path of the light entering the center part, which finally causes serious imaging distortion.

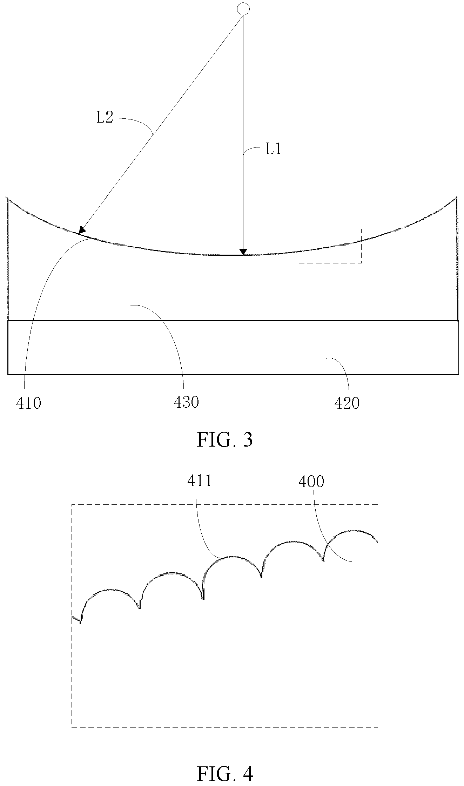

However, in this embodiment of this application, because a height of the outer part is larger and a height of the center part is smaller, L2 can be reduced, so that the difference between L2 and L1 is smaller. As shown in FIG. 3, arrows indicate an exit direction of light.

In the camera module disclosed in this embodiment of this application, because the distance between the center part of the light receiving surface 410 and the lens 200 is slightly different from the distance between the outer part of the light receiving surface 410 and the lens 200, an optical path through which oblique light enters the outer part can be reduced, so that an optical path difference between the center part and the outer part is small, which can effectively alleviate imaging distortion. Certainly, the light receiving surface 410 allows most light to be refracted onto the photosensitive chip module 400 through the lens 200, to facilitate miniaturization of the lens 200. In addition, the light receiving surface 410 formed by splicing the plurality of protrusions 411 distributed in an array can re-gather light that has been gathered by the lens 200, thereby reducing a photosensitive area required by the photosensitive chip module 400, and facilitating a miniaturized design of the camera module.

Further, in an embodiment disclosed in this application, in an optional solution, the photosensitive chip module 400 may include a chip assembly 420 and a light collector 430. Refer to FIG. 3 and FIG. 4. The chip assembly 420 may be disposed on the substrate 300, and may be electrically connected to the substrate 300. In this case, the substrate 300 not only can be used to support the chip assembly 420, but also can be used to control the chip assembly 420.

The light collector 430 may be disposed on the chip assembly 420, and a surface, of the light collector 430, that faces the lens 200 may be the light receiving surface 410. In this manner, imaging distortion of the camera module can be effectively alleviated. In addition, because the light receiving surface 410 is provided on the light collector 430, excessively high costs of the camera module caused by providing the light receiving surface 410 on the chip assembly 420 can be avoided. In addition, in this manner, integrity of the chip assembly 420 can also be ensured.

Certainly, the light collector 430 may be an optical adhesive part. Optical adhesive is characterized by colorless transparency, high transmittance, and the like, which helps light pass through the light collector 430 and be irradiated onto the chip assembly 420. In addition, the light collector 430 formed by the optical adhesive has superb bonding performance, so that an entirety formed by the light collector 430 and the chip assembly 420 can meet an optical path design requirement, and an imaging effect of the chip assembly 420 can be maintained. Certainly, the optical adhesive may be natural resin optical adhesive or synthetic resin optical adhesive. This is not limited in this embodiment of this application.

Further, in a case that the light collector 430 is optical adhesive, the light collector 430 may be a mold-pressed part. During specific processing, optical adhesive may be first applied to a surface, of the chip assembly 420, that faces the lens 200, and is then molded by using a mold, so that the optical adhesive forms the required light collector 430. This manner not only facilitates molding of the light collector 430, but also makes the light collector 430 be better attached to the chip assembly 420, so that an entirety formed by the light collector 430 and the chip assembly 420 can better meet an optical path design requirement, and an imaging effect of the chip assembly 420 can be maintained.

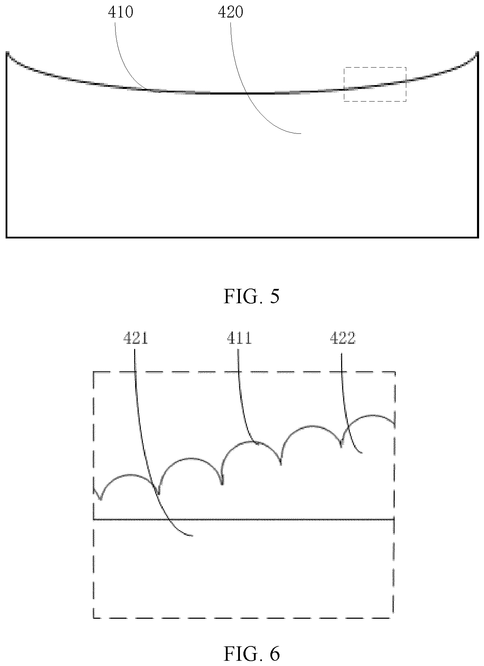

In this embodiment of this application, in another optional embodiment, the photosensitive chip module 400 may include a chip assembly 420, and the chip assembly 420 may include a photosensitive chip 421 and a microlens array 422. Refer to FIG. 5 and FIG. 6. The photosensitive chip 421 is a device for converting an optical signal into an electrical signal. The photosensitive chip 421 may be disposed on the substrate 300 and may be electrically connected to the substrate 300, so that the substrate 300 can carry and control the photosensitive chip 421. The photosensitive chip 421 may be a CCD (Charge-coupled Device, charge-coupled device) photosensitive chip or a CMOS (complementary Metal Oxide Semiconductor, complementary metal oxide semiconductor) photosensitive chip.

The microlens array 422 may be disposed on the photosensitive chip 421. The microlens array 422 may face the lens 200. The microlens array 422 can refract light to form collimated parallel light, so that the light can propagate in the photosensitive chip 421 in a direction perpendicular to a photosensitive surface, and an imaging effect of the photosensitive chip 421 is better.

Further, in this embodiment of this application, the microlens array 422 may include a plurality of microlenses, heights of the plurality of microlenses may gradually increase from a center of the photosensitive chip 421 to the periphery, an end, of the microlens, that faces the lens 200 may be the protrusion 411, and surfaces, of the plurality of microlenses, that face the lens 200 may be spliced into the light receiving surface 410. In this case, imaging distortion of the camera module can be effectively alleviated. In addition, because the microlens array 422 has the light receiving surface 410, excessively high costs of the camera module caused by providing the light receiving surface 410 on the photosensitive chip 421 can be avoided. In addition, in this manner, integrity of the photosensitive chip 421 can also be ensured, so that the photosensitive chip 421 may be a planar photosensitive chip. The photosensitive chip 421 may be a flexible planar photosensitive chip or a rigid planar photosensitive chip. This is not limited in this embodiment of this application.

Certainly, the microlens array 422 may be an optical adhesive part, which can facilitate molding of the microlens array 422 while maintaining an imaging effect of the photosensitive chip 421. Specifically, the microlens array 422 may be a mold-pressed part. During processing, optical adhesive may be applied to a surface, of the photosensitive chip 421, that faces the lens 200, and is then molded by using a mold, so that the optical adhesive forms the required microlens array 422, and the microlens array 422 can be better attached to the photosensitive chip 421.

In an embodiment disclosed in this application, to more effectively alleviate imaging distortion, optionally, heights of the protrusions 411 may gradually increase in a direction from a center of the photosensitive chip module 400 to an edge, so that the plurality of protrusions 411 distributed in an array are spliced into the light receiving surface 410. In this case, the light receiving surface 410 formed by splicing the plurality of protrusions 411 distributed in an array is equivalent to a tapered surface, so that a center part of the light receiving surface 410 is lower than an edge part of the light receiving surface 410, and an optical path difference between the center part of the light receiving surface 410 and the edge part of the light receiving surface 410 is smaller, thereby more effectively alleviating imaging distortion. In addition, the light receiving surface 410 with this structure allows most light to be refracted onto the photosensitive chip module 400 through the lens 200, to facilitate miniaturization of the lens 200.

In this embodiment of this application, the photosensitive chip module 400 may be electrically connected to the substrate 300 in a plurality of manners. In an optional embodiment, a side, of the photosensitive chip module 400, that faces the substrate 300 may be provided with a connecting bump 440. Refer to FIG. 1. The photosensitive chip module 400 may be electrically connected to the substrate 300 through the connecting bump 440. In this case, the connecting bump 440 can make the electrical connection between the photosensitive chip module 400 and the substrate 300 more stable. In addition, the connecting bump 440 can make the photosensitive chip module 400 suspended over the photosensitive chip module 400, to prevent the substrate 300 from interfering with operation of the photosensitive chip module 400.

Further, the side, of the photosensitive chip module 400, that faces the substrate 300 may be provided with a plurality of connecting bumps 440 that are distributed at intervals, and the photosensitive chip module 400 may be electrically connected to the substrate 300 through the plurality of connecting bumps 440. In this case, the plurality of connecting bumps 440 make the photosensitive chip module 400 be better carried on the substrate 300, to better improve mounting reliability of the photosensitive chip module 400.

In another optional embodiment, the photosensitive chip module 400 may be electrically connected to the substrate 300 through a connecting wire 450. Refer to FIG. 2. In this manner, reliability of the electrical connection between the photosensitive chip module 400 and the substrate 300 can be better, so that the substrate 300 can better control the photosensitive chip module 400. In addition, in this manner, the photosensitive chip module 400 can be directly located on a surface of the substrate 300, so that mounting stability of the photosensitive chip module 400 is better. The connecting wire 450 may be made of a conductive metal, alloy, or non-metal material or the like.

In this embodiment of this application, in a case that the camera module is applied to an electronic device, the camera module needs to be electrically connected to functional devices (for example, a main board and a battery) in the electronic device, so that the camera module can implement data transmission, charging, and other work. In an optional embodiment, the camera module may further include a flexible printed circuit board 500. The flexible printed circuit board 500 may be electrically connected to the substrate 300, so that the camera module can be electrically connected to the functional devices in the electronic device through the flexible printed circuit board 500. The flexible printed circuit board 500 can be flexibly disposed based on a specific spatial layout in the electronic device, so that design difficulty can be reduced for a designer. In addition, the flexible printed circuit board 500 has advantages of high wiring density, light weight, and thinness, which facilitates a light and thin design of the electronic device.

Generally, the flexible printed circuit board 500 may be directly welded to the functional devices in the electronic device. However, in this manner, an operation is complex and inconvenient when the flexible printed circuit board 500 needs to be replaced due to damage. Based on this, in an optional embodiment, the camera module may further include a connector 600, and the connector 600 may be electrically connected to the flexible printed circuit board 500. The flexible printed circuit board 500 may be electrically connected to the functional devices in the electronic device through the connector 600. Connection of the connector 600 is reliable, and the connector 600 can implement detachable connection between the flexible printed circuit board 500 and the functional devices in the electronic device, so that a replacement operation of the flexible printed circuit board 500 is simple, and maintainability of the electronic device can be improved.

In this embodiment of this application, the camera module may further include a filter 700, the filter 700 may be disposed on the bracket 100, and the filter 700 may be located between the lens 200 and the photosensitive chip module 400. The filter 700 may filter stray light to improve imaging quality of the camera module. For example, the filter 700 may be configured to filter infrared light to reduce impact of the infrared light on the photosensitive chip module 400, thereby preventing infrared light from generating infrared glare on the photosensitive chip module 400, and improving imaging quality. Certainly, the filter 700 may alternatively filter other stray light. This is not limited in this embodiment of this application.

In the camera module disclosed in this embodiment of this application, the bracket 100 and the substrate 300 may form a mounting space 110, the photosensitive chip module 400 may be located in the mounting space 110, and an opening of the mounting space 110 may face the lens 200. In this manner, a structure of the camera module can be more compact. In addition, in a case that the camera module is applied to an electronic device, this manner can further prevent other components in the electronic device from affecting operation of the photosensitive chip module 400.

Based on the camera module disclosed in the embodiments of this application, an embodiment of this application further discloses an electronic device. The disclosed electronic device includes the camera module described in any one of the foregoing embodiments. Specifically, the electronic device may include a housing, and the camera module may be disposed in the housing. Optionally, the housing may be provided with a transparent region, and the camera module may face the transparent region, so that the camera module can perform photographing through the transparent region.

The electronic device disclosed in this embodiment of this application may be a smartphone, a tablet computer, an e-book reader, a wearable device (for example, a smart watch), a game console, or other devices. A specific type of the electronic device is not limited in this embodiment of this application.

The foregoing describes the embodiments of this application with reference to the accompanying drawings. However, this application is not limited to the foregoing specific embodiments. The foregoing specific embodiments are merely illustrative rather than restrictive. As instructed by this application, persons of ordinary skill in the art may develop many other manners without departing from principles of this application and the protection scope of the claims, and all such manners fall within the protection scope of this application.

## Claims

1. A camera module, comprising:
a bracket (100);
a lens (200), wherein the lens (200) is disposed on the bracket (100);
a substrate (300), wherein the substrate (300) is connected to the bracket (100); and
a photosensitive chip module (400), wherein the photosensitive chip module (400) is disposed on the substrate (300), the photosensitive chip module (400) is electrically connected to the substrate (300), the photosensitive chip module (400) is disposed opposite to the lens (200), the photosensitive chip module (400) has a light receiving surface (410) facing the lens (200), the light receiving surface (410) is a concave surface, and the light receiving surface (410) is formed by splicing a plurality of protrusions (411) distributed in an array.

2. The camera module according to claim 1, wherein the photosensitive chip module (400) comprises a chip assembly (420) and a light collector (430), the chip assembly (420) is disposed on the substrate (300) and is electrically connected to the substrate (300), the light collector (430) is disposed on the chip assembly (420), and a surface, of the light collector (430), that faces the lens (200) is the light receiving surface (410).

3. The camera module according to claim 1, wherein the photosensitive chip module (400) comprises a chip assembly (420), the chip assembly (420) comprises a photosensitive chip (421) and a microlens array (422), the photosensitive chip (421) is disposed on the substrate (300) and is electrically connected to the substrate (300), the microlens array (422) is disposed on the photosensitive chip (421), the microlens array (422) comprises a plurality of microlenses, heights of the plurality of microlenses gradually increase from a center of the photosensitive chip (421) to the periphery, an end, of the microlens, that faces the lens (200) is the protrusion (411), and surfaces, of the plurality of microlenses, that face the lens (200) are spliced into the light receiving surface (410).

4. The camera module according to claim 2, wherein the light collector (430) is an optical adhesive part.

5. The camera module according to claim 1, wherein a side, of the photosensitive chip module (400), that faces the substrate (300) is provided with a connecting bump (440), and the photosensitive chip module (400) is electrically connected to the substrate (300) through the connecting bump (440).

6. The camera module according to claim 1, wherein the photosensitive chip module (400) is electrically connected to the substrate (300) through a connecting wire (450).

7. The camera module according to claim 1, wherein the camera module further comprises a flexible printed circuit board (500), and the flexible printed circuit board (500) is electrically connected to the substrate (300).

8. The camera module according to claim 7, wherein the camera module further comprises a connector (600), and the connector (600) is electrically connected to the flexible printed circuit board (500).

9. The camera module according to claim 1, wherein the camera module further comprises a filter (700), the filter (700) is disposed on the bracket (100), and the filter (700) is located between the lens (200) and the photosensitive chip module (400).

10. The camera module according to claim 1, wherein the bracket (100) and the substrate (300) form a mounting space (110), the photosensitive chip module (400) is located in the mounting space (110), and an opening of the mounting space (110) faces the lens (200).

11. An electronic device, comprising the camera module according to any one of claims 1 to 10.
